# EUROPEAN PATENT SPECIFICATION

(11) **EP 1 857 411 B1**
(45) Date of publication and mention of the grant of the patent: **29.10.2008**
(21) Application number: 07252021.6
(22) Date of filing: 17.05.2007
(51) Int. Cl.: C01B 31/00, C23C 16/00, F16D 69/02

(54) **Modified CVD cooling loop**
Modifizierte CVD-Kühlungsschleife
Circuit de refroidissement CVD modifié

(30) Priority: 17.05.2006 US 434802
(43) Date of publication of application: 21.11.2007
(73) Proprietor: Honeywell International Inc., Morristown NJ 07960 (US)
(72) Inventor: Cress, James Jay, Mishawaka, IN 46545 (US); Conn, Mark D., South Bend, IN 46614 (US); Deneve, Michael J., Mishakawa, IN 46544 (US); Stutsman, Michael J., Edwardsburg, MI 49112 (US)
(74) Representative: Hucker, Charlotte Jane

(56) References cited:
- EP-A2- 0 995 960
- US-A- 5 348 774
- US-B1- 6 639 196
- LUO R: "Fabrication of carbon/carbon composites by an electrified preform heating CVI method" CARBON, vol. 40, no. 11, September 2002 (2002-09), pages 1957-1963, XP004371646 ISSN: 0008-6223

## Description

### FIELD OF THE INVENTION

This invention relates the production of carbon-carbon composite materials, and in particular to the production of aircraft brake discs and the like made of carbon-carbon composite materials. More particularly, this invention relates to chemical vapor deposition (CVD) processing cycles which are used to increase the density of carbon-carbon composites intended for use in such demanding applications.

### BACKGROUND OF THE INVENTION

Carbon-carbon composites are widely used as friction materials in aircraft braking systems, where their high thermal conductivity, considerable heat capacity, and excellent friction and wear behavior lead to significantly improved aircraft braking performance. Consequently, large commercial aircraft (e.g., Boeing 747, 757, and 767) and virtually all military aircraft employ carbon-carbon composites in their braking systems.

The manufacturing process for carbon-carbon composites is very lengthy, and as a result carbon-carbon composite materials tend to be quite expensive. Typically, a preform is prepared by hand lay-up of woven carbon fiber fabric segments, or by hot pressing a mixture of chopped carbon fibers and resin (prepreg). The preform is then densified by repetitive liquid impregnation with pitch or resin or by carbon vapor deposition, followed by carbonization and graphitization. Up to 5 cycles of repeated densification and carbonization can be required to achieve the desired density of about 1.8 g/cc, which can take 6 to 9 months.

In the chemical vapor deposition processing cycles which are used to increase the density of carbon-carbon composites intended for use in demanding applications, such as aircraft landing system brake discs and related parts, batches of carbon-carbon composite preforms are loaded into a CVD oven, and infiltrated with carbon-containing gases at extremely high temperatures. At the end of a CVD cycle, the parts must be cooled - typically from approximately 1000°C to approximately 200°C - before the furnace can be opened. Due to the extreme temperatures used in CVD processing, extensive cooling times, e.g. on the order of 40 hours, are normally required. Cooling that is too rapid can damage the CVD furnace and/or the carbon-carbon composite parts that are being densified.

### SUMMARY OF THE INVENTION

The present invention provides an improved overall CVD process, in which the cooling time is significantly reduced, thus making the parts being manufactured available in a shorter period of time (so that they can be delivered to customers earlier) and making the capital equipment (CVD oven, etc.) available for more production runs over a given period of time, reducing capital costs of the carbon-carbon composite part manufacturing process. This invention can provide reductions in cool down times of 50% or greater.

### BRIEF DESCRIPTION OF THE DRAWINGS

The present invention will become more fully understood from the detailed description given hereinbelow and the accompanying drawings. The drawings are not to scale, and are given by way of illustration only. Accordingly, the drawings should not be construed as limiting the present invention.

Figure 1 is a schematic illustration of a conventional cool down loop.

Figure 2 is a schematic illustration of a cool down loop in accordance with the present invention.

Figure 3 is a schematic illustration of another cool down loop in accordance with the present invention.

### DETAILED DESCRIPTION OF THE INVENTION

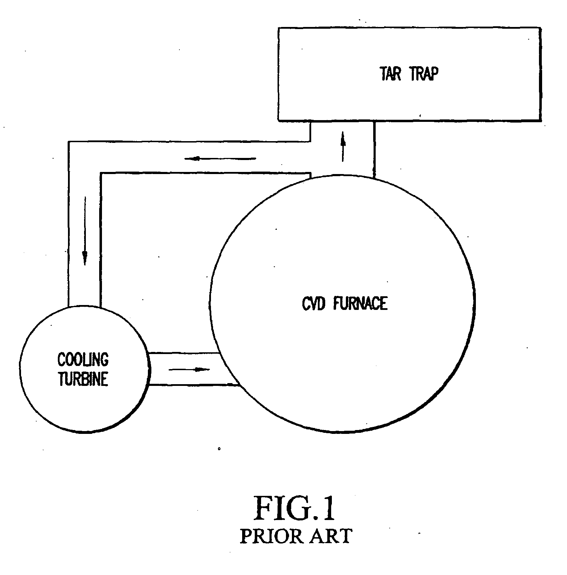

Conventional processing, illustrated in Figure 1, forces cool air from a cooling turbine through the CVD furnace which contains the hot, densified parts. The air absorbs some of the heat from the parts and the furnace (and also may pick up some soot or tarry substances) and then leaves the CVD oven. Subsequently this air is recirculated back through the cooling turbine into the CVD furnace again. This set up has a tar trap located prior to the recirculation loop. The tar trap removes the soot or tarry material picked up in the CVD furnace by the cooling air.

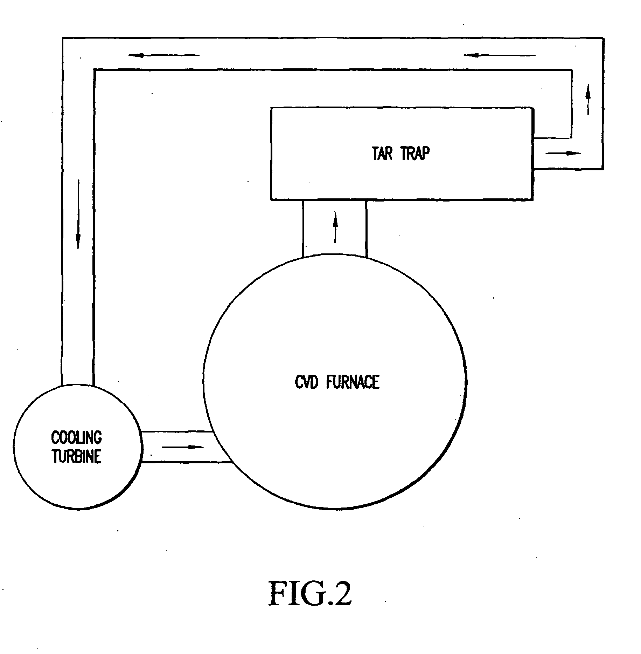

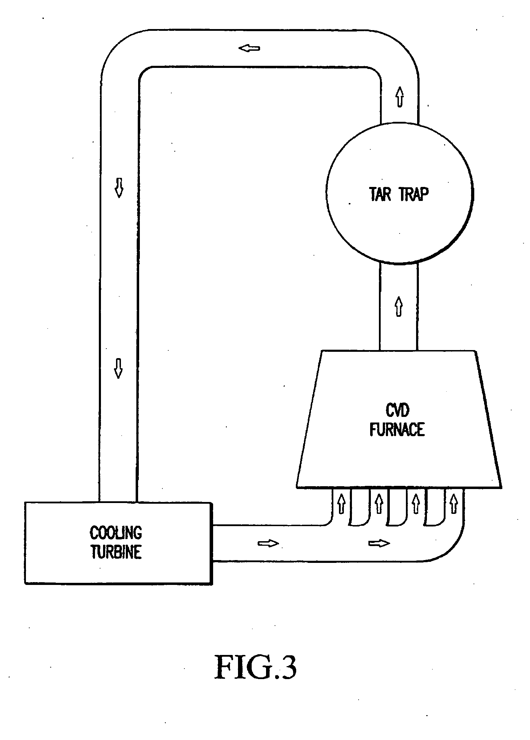

Processing in accordance with the present invention is illustrated in Figure 2 and in Figure 3. In this invention, forced cool air from the cooling turbine passes through the CVD furnace, absorbs heat (and possibly soot and/or tar) and then is passed through the tar trap before it is returned to the cooling turbine. The resulting air is both lower in tar and cooler than the air returned to the cooling turbine in conventional processing.

This invention provides a process for increasing the density of carbon-carbon composite part. The method of this invention may include several consecutive steps, as follows. Step (a.) is providing the carbon-carbon composite parts, e.g. aircraft brake disc preforms. In step (b.), the carbon-carbon composite parts are subjected to chemical vapor deposition in a CVD furnace, e.g. at a temperature in the range 1000-2000°C. Step (c.) involves forcing cooling air (typically, air at ambient temperature) through the CVD furnace, where it absorbs heat and becomes warmed air. In step (d.) of the present invention, this warmed air is then passed through a tar trap, e.g. at a rate of 1524 m (5000 feet) per second, where its content of soot and/or tar is reduced. Step (e.) is cooling the purified, warmed air. This is typically passive cooling, by conduction through the walls of equipment employed to channel the cooling air. Steps (c.) - (e.) are then repeated continuously, for instance over a period of about 24 hours. Finally, the resulting densified carbon-carbon composite parts are removed from the CVD furnace.

### EXAMPLES

The following tables illustrate CVD cooling cycle time improvements provided by the present invention.

| CVD 20 | | | |
|---|---|---|---|
| Start temperature | End temperature | Elapsed time | Time savings* |
| 1015°C | 215°C | 39.84250 hours | n.a. |
| 1014°C | 215°C | 42.17944 hours | n.a. |
| 1022°C | 214°C | 44.01083 hours | n.a. |
| | | | |
| 1012°C | 218°C | 18.92139 hours | 23.08954 hours |
| 1031°C | 218°C | 19.50472 hours | 22.50620 hours |
| 1034°C | 200°C | 18.67056 hours | 23.34037 hours |
| 1027°C | 213°C | 14.50389 hours | 27.50704 hours |
| 1033°C | 201°C | 15.54667 hours | 26.46426 hours |
| 1021°C | 199°C | 13.83917 hours | 28.17176 hours |
| 1030°C | 200°C | 15.50333 hours | 26.50759 hours |
| 1013°C | 200°C | 13.67000 hours | 28.34093 hours |
| 1012°C | 208°C | 13.17167 hours | 28.83926 hours |
| * The first three runs are conventional. Their average elapsed time (42.01093 hours) is used as the baseline for the time savings calculation. | | | |

| CVD 21 | | | |
|---|---|---|---|
| Start temperature | End temperature | Elapsed time | Time savings* |
| 1018°C | 232°C | 43.71250 hours | n.a. |
| 1012°C | 213°C | 58.10417 hours | n.a. |
| 1024°C | 201°C | 39.01556 hours | n.a. |
| 1024°C | 211°C | 41.67972 hours | n.a. |
| | | | |
| 1023°C | 208°C | 20.67361 hours | 24.95438 hours |
| 1025°C | 200°C | 15.67250 hours | 29.95549 hours |
| 1025°C | 205°C | 16.21861 hours | 29.40937 hours |
| 1019°C | 201°C | 16.08833 hours | 29.53965 hours |
| 1025°C | 215°C | 15.25583 hours | 30.37215 hours |
| 1021°C | 227°C | 15.17222 hours | 30.45576 hours |
| * The first four runs are conventional. Their average elapsed time (45.62799 hours) is used as the baseline for the time savings calculation. | | | |

| CVD 23 | | | |
|---|---|---|---|
| Start temperature | End temperature | Elapsed time | Time savings* |
| 1013°C | 203°C | 43.76139 hours | n.a. |
| 1014°C | 201°C | 45.68472 hours | n.a. |
| 1021°C | 201°C | 42.86194 hours | n.a. |
| | | | |
| 1009°C | 200°C | 14.92111 hours | 29.18157 hours |
| 1010°C | 205°C | 14.83778 hours | 29.26491 hours |
| 1006°C | 210°C | 15.58806 hours | 28.51463 hours |
| 1018°C | 228°C | 17.09111 hours | 27.01157 hours |
| 1013°C | 202°C | 16.59028 hours | 27.51241 hours |
| 1012°C | 203°C | 16.50556 hours | 27.59713 hours |
| 1014°C | 201°C | 15.58833 hours | 28.51435 hours |
| *The first three runs are conventional. Their average elapsed time (44.10269 hours) is used as the baseline for the time savings calculation. | | | |

The present invention has been described herein in terms of preferred embodiments. However, obvious modifications and additions to the invention will become apparent to those skilled in the relevant arts upon a reading and understanding of the foregoing description. It is intended that all such modifications and additions form a part of the present invention to the extent that they fall within the scope of the several claims appended hereto.

## Claims

1. A process for increasing the density of a carbon-carbon composite part, which method comprises the steps of:
(a.) providing a carbon-carbon composite part;
(b.) subjecting said carbon-carbon composite part to chemical vapor deposition in a CVD furnace;
(c.) forcing cooling air through the CVD furnace, where it absorbs heat and becomes warmed air;
(d.) passing said warmed air through a tar trap where its content of soot and/or tar is reduced;
(e.) cooling the purified, warmed air;
(f.) repeating steps (c.) - (e.); and finally
(g.) removing the resulting densified carbon-carbon composite part from the CVD furnace.

2. The process of claim 1, wherein the part provided in step (a.) is an aircraft brake disc preform.

3. The process of claim 1, wherein CVD processing in step (b.) is conducted at a temperature in the range 1000-2000°C.

4. The process of claim 1, wherein the cooling air in step (c.) is air that is at ambient temperature.

5. The process of claim 1, wherein in step (d.) air is passed through the tar trap at a rate of 1524 m (5000 feet) per second.

6. The process of claim 1, wherein the cooling in step (e.) is passive cooling, by conduction through the walls of equipment employed to channel the cooling air.

7. The process of claim 1, wherein step (f.) is repeated continuously over a period of 24 hours.

8. A method of improving the economics of CVD processing of carbon-carbon composite parts, which method comprises the steps of:
reducing the amount of time required for post-cooling a first batch of densified carbon-carbon composite parts in a CVD furnace relative to the amount of time that would be required by processing that does not include step (d.) by practicing the process of claim 1, thereby providing a period of extra CVD furnace availability; and
employing the CVD furnace to densify a second batch of carbon-carbon composite parts during the period of extra furnace availability.

9. The method of claim 8, wherein the period of extra furnace availability is approximately equal to the amount of time required for post-cooling said first batch of densified carbon-carbon composite parts.

## Patentansprüche

1. Prozess zum Erhöhen der Dichte eines Kohlenstoff-Kohlenstoff-Verbundteils, wobei das Verfahren die folgenden Schritte umfasst:
(a.)Bereitstellen eines Kohlenstoff-Kohlenstoff-Verbundteils;
(b.)Einwirken einer chemischen Dampfabscheidung (CVD) auf das Kohlenstoff-Kohlenstoff-Verbundteil in einem CVD-Ofen;
(c.)Drücken von Kühlluft durch den CVD-Ofen, wo sie Wärme aufnimmt und zu erwärmter Luft wird;
(d.)Durchströmen eines Teerabscheiders mit der erwärmten Luft, wobei ihr Gehalt an Ruß und/oder Teer reduziert wird;
(e.)Kühlen der gereinigten, erwärmten Luft;
(f.)Wiederholen der Schritte (c.) - (e.); und schließlich
(g.)Entfernen des sich ergebenden verdichteten Kohlenstoff-Kohlenstoff-Verbundteils aus dem CVD-Ofen.

2. Prozess nach Anspruch 1, wobei das Teil, das in Schritt (a.) bereitgestellt ist, ein Flugzeug-Bremsscheiben-Vorformling ist.

3. Prozess nach Anspruch 1, wobei die CVD-Verarbeitung in Schritt (b.) bei einer Temperatur im Bereich 1000-2000 °C ausgeführt wird.

4. Prozess nach Anspruch 1, wobei die Kühlluft in Schritt (c.) Luft ist, die Umgebungstemperatur hat.

5. Prozess nach Anspruch 1, wobei in Schritt (d.) Luft durch den Teerabscheider mit einer Rate von 1524 m (5000 Fuß) pro Sekunde geschickt wird.

6. Prozess nach Anspruch 1, wobei die Kühlung in Schritt (e.) passive Kühlung ist, die durch Wärmeleitung durch die Wände der Anlage erfolgt, welche zum Leiten der Kühlluft verwendet wird.

7. Prozess nach Anspruch 1, wobei Schritt (f.) fortlaufend über einen Zeitraum von 24 Stunden wiederholt wird.

8. Verfahren zum Verbessern der Wirtschaftlichkeit der CVD-Verarbeitung von Kohlenstoff-Kohlenstoff-Verbundteilen, wobei das Verfahren folgende Schritte umfasst:
Reduzieren der Zeitdauer, die zum Nachkühlen einer ersten Charge von verdichteten Kohlenstoff-Kohlenstoff-Verbundteilen in einem CVD-Ofen im Verhältnis zu der Zeitdauer benötigt ist, welche für die Verarbeitung erforderlich wäre, die Schritt (d.) nicht enthält, durch Ausführen des Prozesses nach Anspruch 1, wodurch ein Zeitraum einer zusätzlichen Verfügbarkeit des CVD-Ofens erreicht wird; und
Verwendung des CVD-Ofens zum Verdichten einer zweiten Charge von Kohlenstoff-Kohlenstoff-Verbundteilen während der Zeit der zusätzlichen Verfügbarkeit des Ofens.

9. Verfahren nach Anspruch 8, wobei die Zeit der zusätzlichen Ofenverfügbarkeit ungefähr gleich der Zeitdauer ist, die zum Nachkühlen der ersten Charge der verdichteten Kohlenstoff-Kohlenstoff-Verbundteile erforderlich ist.

## Revendications

1. Procédé pour augmenter la densité d'une pièce composite de carbone - carbone, ledit procédé comprenant les étapes consistant à:
(a) fournir une pièce composite de carbone - carbone;
(b) soumettre ladite pièce composite de carbone - carbone à un dépôt chimique en phase vapeur dans un four CVD;
(c) injecter de l'air de refroidissement à l'intérieur du four CVD, dans lequel il absorbe de la chaleur et se transforme en air chaud;
(d) faire passer ledit air chaud à travers un piège à goudrons où sa teneur en suie et/ou en goudron est réduite;
(e) refroidir l'air chaud purifié;
(f) répéter les étapes (c) - (e); et enfin
(g) sortir la pièce composite de carbone - carbone densifiée obtenue hors du four CVD.

2. Procédé selon la revendication 1, dans lequel la pièce fournie à l'étape (a) est une préforme de disque de frein pour avion.

3. Procédé selon la revendication 1, dans lequel le traitement CVD exécuté à l'étape (b) est réalisé à une température comprise dans la gamme de 1000°C à 2000°C.

4. Procédé selon la revendication 1, dans lequel l'air de refroidissement injecté à l'étape (c) est de l'air qui se trouve à la température ambiante.

5. Procédé selon la revendication 1, dans lequel à l'étape (d), l'air est passé à travers le piège à goudrons à une vitesse de 1524 mètres (5000 pieds) par seconde.

6. Procédé selon la revendication 1, dans lequel le refroidissement exécuté à l'étape (e) est un refroidissement passif qui est réalisé par conduction à travers les parois de l'équipement employé pour canaliser l'air de refroidissement.

7. Procédé selon la revendication 1, dans lequel l'étape (f) est répétée de façon continue sur une période de 24 heures.

8. Méthode pour améliorer le rendement d'un traitement CVD de pièces composites de carbone - carbone, ladite méthode comprenant les étapes consistant à:
réduire la quantité de temps nécessaire pour le post-refroidissement d'un premier lot de pièces composites de carbone - carbone densifiées dans un four CVD par rapport à la quantité de temps qui serait requise par un traitement ne comprenant pas l'étape (d) pour exécuter le procédé selon la revendication 1, créant ainsi une période de disponibilité supplémentaire du four CVD; et
employer le four CVD pour densifier un deuxième lots de pièces composites de carbone - carbone pendant la période de disponibilité supplémentaire du four.

9. Méthode selon la revendication 8, dans laquelle la période de disponibilité supplémentaire du four est approximativement égale à la quantité de temps qui est nécessaire pour le post-refroidissement dudit premier lot de pièce composites de carbone - carbone densifiées.
